(19) Europäisches Patentamt
European Patent Office
Office européen des brevets

(11) **EP 1 701 376 B1**

(12) **EUROPÄISCHE PATENTSCHRIFT**

(45) Veröffentlichungstag und Bekanntmachung des Hinweises auf die Patenterteilung:
**08.11.2006 Patentblatt 2006/45**

(51) Int Cl.:
*H01J 37/32* (2006.01)

(21) Anmeldenummer: **05005248.9**

(22) Anmeldetag: **10.03.2005**

(54) **Vakuumplasmagenerator**

Vacuum plasma generator

Generateur de plasma sous vide

(84) Benannte Vertragsstaaten:
**AT BE BG CH CY CZ DE DK EE ES FI FR GB GR HU IE IS IT LI LT LU MC NL PL PT RO SE SI SK TR**

(43) Veröffentlichungstag der Anmeldung:
**13.09.2006 Patentblatt 2006/37**

(73) Patentinhaber: **HÜTTINGER Elektronik GmbH + Co. KG**
**79111 Freiburg (DE)**

(72) Erfinder:
• **Glück, Michael**
**79111 Freiburg (DE)**

• **Hofstetter, Christoph**
**79331 Teningen (DE)**
• **Hintz, Gerd, Dr.**
**79292 Pfaffenweiler (DE)**

(74) Vertreter: **Kohler Schmid Möbus**
**Patentanwälte**
**Ruppmannstrasse 27**
**70565 Stuttgart (DE)**

(56) Entgegenhaltungen:
**WO-A-03/079397      US-A1- 2001 026 575**
**US-A1- 2003 215 373      US-A1- 2004 032 212**
**US-A1- 2004 222 184**

**Beschreibung**

Die Erfindung betrifft einen Vakuumplasmagenerator zur Behandlung von Werkstücken in einer Vakuumkammer.

Solche Vakuumplasmageneratoren werden zum Beispiel in der Halbleiterfertigung zum Beschichten und Ätzen eingesetzt. Die Prozesse erfordern häufig eine hochfrequente (HF-) Leistung im Bereich von 1-30 MHz und mehreren kW Leistung. Plasmalasten, also Plasmaprozesse in einer Vakuumkammer, sind sehr dynamisch und neigen zu Überschlägen. Bei HF-Anwendungen kommt es daher zu Nichtanpassungen und damit zu Reflexionen.

Vakuumplasmageneratoren weisen zumeist mindestens einen Verstärker zur Erzeugung eines energiereichen HF-Signals auf. Bei Nichtanpassung wird die Energie von der Last reflektiert. Die reflektierte Energie wird nur zum Teil - meist nur zu einem sehr geringen Teil - in dem Verstärker des Vakuumplasmagenerators abgefangen und in Wärme umgewandelt. Die meiste Energie wird in der Regel auch vom Verstärker reflektiert. Es kommt zu Mehrfachreflexionen und damit zu stehenden Wellen. Dies kann zu sehr großen Energien führen, die sich zwischen dem Verstärker und der Plasmalast aufschwingen und sowohl in der Plasmalast als auch in dem Verstärker zur Zerstörungen führen können.

Aus der US 6,703,080 B2 ist ein Generator bekannt, der an ein Schaltnetzteil angeschlossen werden kann und der an eine Treiberstufe angeschlossen ist. Die Treiberstufe liefert ein HF-Signal an eine Verstärkerstufe, wo das HF-Signal zunächst auf mehrere Pfade aufgeteilt wird, anschließend in den Pfaden verstärkt wird und schließlich wieder zu einem verstärkten HF-Signal in einem 3dB-Koppler gekoppelt wird. Um die Verstärkerstufe von den Impedanzänderungen der Last zu entkoppeln, ist eine Isolationsstufe vorgesehen, die einen Zirkulator aufweist.

Vakuumplasmageneratoren sollten eine möglichst geringe Baugröße aufweisen. Dann können sie nahe an den Vakuumkammern montiert werden und es sind keine langen teuren Kabel notwendig.

In der Halbleiterfertigung müssen solche Generatoren dann die Erfordernisse von Reinräumen erfüllen. Ein forcierter Luftaustausch vom Innern der Generatoren in die Umgebungsluft mittels Lüftern ist hier unerwünscht. Die Vakuumplasmageneratoren werden in unterschiedlichen Ländern mit unterschiedlichen Netzspannungen und Frequenzen eingesetzt. Ihr Einsatzbereich ist zumeist in der Industrie mit hohen Anforderungen an die Störsicherheit bei zumeist gleichzeitig hohen Störspannungen auf den Stromversorgungsnetzen und an der Last.

Aufgabe der vorliegenden Erfindung ist es, einen Vakuumplasmagenerator zu schaffen, der verlustarm arbeitet und wenig anfällig für externe Störungen ist und mit einer möglichst geringen Anzahl von Bauteilen auskommt und eine geringe Baugröße aufweist und vielseitig (in möglichst vielen Ländern und Einsatzgebieten) einsetzbar ist.

Diese Aufgabe wird erfindungsgemäß dadurch gelöst, dass der Vakuumplasmagenerator aufweist:

- einen Netzanschluss für den Anschluss an ein Spannungsversorgungsnetz;
- mindestens einen Netzgleichrichter, verbunden mit
- mindestens einem ersten Konverter zur Erzeugung mindestens einer Zwischenkreisspannung;
- einen ersten an die mindestens eine Zwischenkreisspannung angeschlossenen HF-Signalerzeuger zur Erzeugung eines ersten Signals einer Grundfrequenz, insbesondere im Bereich von 1 bis 30MHz, und einer ersten Phasenlage;
- einen zweiten an eine Zwischenkreisspannung angeschlossenen HF-Signalerzeuger zur Erzeugung eines zweiten Signals der Grundfrequenz und einer zweiten Phasenlage;
- mindestens einen 3dB-Koppler, der das erste und das zweite Signal zu einem Ausgangssignal koppelt und an
- einen Generatorausgang mittelbar oder unmittelbar übergibt.

Der Vorteil des Netzgleichrichters und Konverters liegt in der Störunempfindlichkeit gegenüber Störungen aus dem Netz, insbesondere können mit einer geregelten Zwischenkreisspannung kurzzeitige Netzunterbrechungen und/oder Netzspannungsabsenkungen ausgeglichen werden. Dies ist insbesondere in der Halbleiterfertigung eine wichtige Forderung an die zu verwendenden Generatoren.

Mit dem Einsatz eines Netzgleichrichters kann das Spannungsversorgungsnetz ein Wechselspannungsnetz unterschiedlicher Frequenzen sein. Es kann auch ein Gleichspannungsnetz sein, insbesondere ist bei einem Gleichspannungsnetz mit dem Netzgleichrichter ein Verpolschutz integriert.

Der 3dB-Koppler ist ein Viertor, das im Idealfall eine 45° Phasenverschiebung bewirkt, wenn das Signal den 3dB-Koppler überquert. Real ergeben sich Abweichungen auf Grund der Laufzeit von wenigen Grad. Wenn zwei HF-Signale mit einem 90° Phasenversatz in die Tore A und B gehen, wird auf dem Weg zum Tor C das eine HF-Signal um +45° und das andere um - 45° phasenverschoben, so dass sich die Signale des ersten und zweiten HF-Signalerzeugers, die jeweils auf das Tor A bzw. B gehen, am Tor C auslöschen. Es liegt keine Leistung am Tor C. Die Leistungen der beiden HF-Signalerzeuger erscheinen kombiniert am Tor D, da die Signale des ersten und zweiten Signalerzeugers einen Phasenversatz von -45° bzw. +45° im 3dB-Koppler erfahren, so dass sie am Tor D gleichphasig sind. Wenn ein Lastausgleichswiderstand am Tor C angeordnet ist, wird dort keine Leistung verbraucht und 100% der Leistung geht in die Plasmalast, die an Tor D angeschlossen ist.

Dabei weist der 3dB-Koppler einen entscheidenden Vorteil gegenüber vielen anderen Kopplern auf. Die reflektierte Leitung wird vom 3dB-Koppler in zwei Pfade aufgespaltet, die zurück zu den HF-Signalerzeugern gehen. Die Amplitude des reflektierten Signals ist in beiden Pfaden dieselbe, jedoch haben die Signale einen 90° Phasenversatz. Sind die zu kombinierenden HF Signalerzeuger gleich aufgebaut, so sind auch deren Reflektionsfaktoren gleich. Die von der Last reflektierte Leistung wird somit wieder von den HF-Signalerzeugern reflektiert. Verursacht durch die Phasendrehung bei den Reflektionen wird die reflektierte Leistung nun aber nicht an die Last zurückgeleitet, sondern auf den Lastausgleichswiderstand am Tor C. Schließt man dieses mit einem Absorberwiderstand $R = Z_0 =$ Wellenwiderstand ab, so wird die von der Last reflektierte Leistung in dem Absorberwiderstand vollständig verbraucht und nicht nochmals reflektiert. Die reflektierten HF-Signale löschen sich am Tor D gegenseitig aus. Dies ist einer der bedeutendsten Vorteile einer Kombination zweier HF- Signalerzeuger über einen 3dB-Koppler. Es kommt zu keinen Mehrfachreflexionen mehr.

Der 3dB-Koppler bildet dabei eine Schutzschaltung, die bei auftretenden Reflexionen durch unterschiedliche Lastzustände ein Zerstören der angeschlossenen HF-Signalerzeuger verhindert und so auch bei diesen Anwendungen einen sicheren Betrieb von transistorisierten HF-Signalerzeugern ermöglicht.

Impedanzänderungen der Last haben folglich nur geringe Auswirkungen auf die Stabilität des Generators. Der Generator zeichnet sich weiterhin durch einen besonders einfachen Aufbau aus. Insbesondere ist im Gegensatz zum Stand der Technik kein Splitter notwendig, um HF-Leistung zunächst in zumindest zwei Pfade aufzuteilen. Auch ist kein Zirkulator notwendig. Besonders vorteilhaft ist, dass der zweite HF-Signalerzeuger an dieselbe Zwischenkreisspannung angeschlossen werden kann.

Bei einer besonders bevorzugten Ausführungsform kann vorgesehen sein, dass der erste und zweite HF-Signalerzeuger jeweils als Inverter ausgebildet sind, die von einer Steuer- und/oder Regeleinrichtung angesteuert sind. Mit einem Inverter, insbesondere durch die geeignete Ansteuerung eines Inverters, kann eine einfache Phaseneinstellung seines Ausgangssignals erfolgen. Dadurch ergibt sich eine besondere Flexibilität der Phaseneinstellung. Auch Phasenunterschiede, die sich einstellen, wenn die Signalpfade, in denen sich die unterschiedlichen Inverter befinden, unterschiedlich lang sind, können einfach ausgeglichen werden. Weiterhin ist vorteilhaft, dass die Inverter als Verstärker betreibbar sind. Durch geeignete Ansteuerung können die hochfrequenten Signale, insbesondere hochfrequente Wechselspannungen, in ihrer Frequenz verändert werden. Dabei kann die eingestellte Phasenlage im Wesentlichen beibehalten werden. Die Frequenzvariation ist vorteilhaft, wenn die Impedanz des Vakuumplasmagenerators an die Impedanz des Plasmas angepasst werden soll, ohne das Impedanzanpassungsnetzwerk zu verändern.

Häufig werden HF Plasmaprozesse mit festen, nicht dynamisch regelbaren Impedanzanpassungsnetzwerken betrieben, sogenannten Fixmatch-Anordnungen. Um eine Impedanzanpassung zu erreichen, wird die Grundfrequenz in vorgegebenen Grenzen variiert. Die restliche Fehlanpassung wird hingenommen. Gerade diese führt aber bei herkömmlichen Vakuumplasmageneratoren zu Mehrfachreflexionen. Bei dem erfindungsgemäßen Vakuumplasmagenerator kommt es zu keinen Mehrflachreflexionen mehr.

Vorzugsweise weisen die Inverter jeweils wenigstens ein schaltendes Element auf, das bei einer Grundfrequenz ein- und ausgeschaltet wird. Das schaltende Element kann ein Transistor, insbesondere ein MOS-FET Transistor, sein.

Vorzugsweise besitzt die Steuer- und/oder Regeleinrichtung je einen synchron angesteuerten Steuerausgang für jeden Inverter zur Amplitudenmodulation insbesondere zum Pulsen der HF Leistung. Amplitudenmodulation, insbesondere Pulsen, ist in modernen Vakuumplasmaprozessen in zunehmendem Maße gefordert. Auch hier zeigen sich die Vorteile des erfindungsgemäßen Generators deutlich. Bei Amplitudenmodulation und vor allem beim Pulsen ändert sich die Last besonders dynamisch. Eine Impedanzanpassung kann mit der Pulsfrequenz zumeist nicht erfolgen. Die Pulsfrequenz liegt häufig im Bereich 100 Hz - 100 kHz. Bei diesen Frequenzen ist eine Impedanzanpassung nicht möglich, da Impedanzanpassungsnetzwerke zu langsam reagieren. Es kommt also zu Reflexionen. Der erfindungsgemäße Generator verhindert aber Mehrfachreflexionen, insbesondere verhindert er auch, dass die reflektierte Leistung zurück zum Plasmaprozess reflektiert wird.

In Zusammenhang mit Invertern werden die Vorteile der Verwendung eines 3dB-Kopplers besonders deutlich. Inverter lassen sich durch reflektierte Leistung in ihrem Betriebsverhalten stören. Insbesondere solche Schaltungen, bei denen ein den Invertern nachgeschaltetes Impulsformungsnetzwerk dafür ausgelegt ist, dass die schaltenden Elemente besonders verlustarm betrieben werden (Einschalten bei möglichst geringer Spannung am schaltenden Element), können die Reflexionen und insbesondere die Mehrfachreflexionen zu Störungen der Inverter führen. Ein 3dB-Koppler lässt also diese Inverterschaltungen sicherer arbeiten. Die Leistungssteuerung bei solchen Inverterschaltungen kann über die Steuerung der Zwischenkreisspannung erfolgen. Dann können besonders verlustarme und einfach zu realisierende Inverter verwendet werden, z.B solche mit nur einem schaltenden Element.

Bei einer bevorzugten Weiterbildung können die Inverter jeweils eine Halb- oder Vollbrücke aufweisen. Die Leistung bei Brückenschaltungen kann mittels Pulsweitenmodulation oder Phase Shift Modulation gesteuert werden. Eine Leistungssteuerung über die Zwischenkreisspannung ist dann nicht erforderlich.

Die Leistung am Generatorausgang kann auch durch Phasenunterschiede der beiden Inverter zueinander gesteuert werden. Liegen die Signale der Inverter nicht 90° phasenverschoben, so wird nur ein Teil der Leistung zum Generatorausgang geleitet, der andere Teil wird auf den Lastausgleichswiderstand geleitet. Auf diese Weise lässt sich eine sehr schnelle Leistungssteuerung realisieren.

Bei einer vorteilhaften Ausgestaltung der Erfindung ist dem ersten und zweiten HF-Signalerzeuger jeweils ein Impulsformungsnetzwerk nachgeschaltet. Die Inverter liefern an ihren Ausgängen jeweils ein Rechtecksignal bzw. ein digitales Signal. Dieses Signal kann durch ein Impulsformungsnetzwerk in ein sinusförmiges Signal umgewandelt werden. Dadurch können Oberwellen gefiltert werden und können die schaltenden Elemente der Inverter besonders verlustarm geschaltet werden. Dazu ist es vorteilhaft, wenn das Impulsformungsnetzwerk im Wesentlichen auf die Grundfrequenz abgestimmt ist. Es können weitere Inverter mit nachgeschalteten Impulsformungsnetzwerken vorgesehen sein. Außerdem können weitere 3dB-Koppler vorgesehen sein, die die hochfrequenten Signale kaskadenförmig koppeln, insbesondere auf einen Ausgangsanschluss des Vakuumplasmagenerators koppeln.

Wenn der oder die Inverter, die Impulsformungsnetzwerke oder der 3dB-Koppler an ihren Ausgängen über Kondensatoren galvanisch entkoppelt sind, sind keine Übertrager zur galvanischen Entkopplung notwendig.

Besonders bevorzugt ist es, wenn der 3dB-Koppler mindestens einen ersten und einen zweiten elektrischen Leiter, die voneinander beabstandet sind, und die kapazitiv und induktiv miteinander gekoppelt sind, aufweist, wobei der erste Leiter die Primärseite und der zweite Leiter die Sekundärseite eines Übertragers darstellen, der eine Koppelinduktivität aufweist, und der erste und der zweite Leiter jeweils eine Windungszahl n > 1 aufweisen. Durch diese einfache Maßnahme kann die Induktivität auf einfache Art und Weise erhöht werden. Die Induktivität (=Koppelinduktivität) steigt mit der Anzahl der Windungen im Quadrat, mit einer Verdopplung der Windungszahl erhöht sich die Induktivität demnach um den Faktor vier. Die Größe eines Induktivitätserhöhungselements kann sich demnach bei der Verdopplung der Windungszahl um den Faktor 4 verkleinern. Damit kann die Baugröße durch Verwendung von mehr als einer Windung reduziert werden. Bei einer ausreichend hohen Windungszahl kann im Idealfall auf weitere induktivitätserhöhende Maßnahmen verzichtet werden. Der 3dB-Koppler kann dabei bei Frequenzen < 100MHz betrieben werden, also bei deutlich kleineren Frequenzen als im Stand der Technik der US 6,703,080 B2, so dass die Leitungstheorie keine Rolle spielt.

Eine alternative oder zusätzliche Möglichkeit, die Induktivität zu erhöhen, besteht darin, dass der 3dB-Koppler in einem Kopplungsbereich zur Erhöhung der Induktivität der Leiter zumindest ein Induktivitätserhöhungselement aufweist. Dabei kann das Induktivitätserhöhungselement eine beliebige Form haben. Vorzugsweise umgibt es die Leiter im Kopplungsbereich zumindest teilweise. Es kann z.B. parallel zu ihnen liegen. Dadurch kann eine besonders einfache und effektive Kopplung erreicht werden. Bevorzugt wird das Induktivitätserhöhungselement die Leiter im Kopplungsbereich ringförmig umgeben. Dabei ist mit ringförmig gemeint, dass die Leiterabschnitte im Kopplungsbereich von einer weitestgehend geschlossenen Geometrie umgeben sind, sie kann kreisförmig, elliptisch, rechteckig oder anders geformt sein. Der Vorteil einer ringförmigen Geometrie ist die Reduzierung von Streufeldern. Das induktionserhöhende Element kann als Ferrit ausgebildet sein.

Die kapazitive Kopplung mittels einer Koppelkapazität kann mittels zweier beabstandeter elektrischen Leiter mit einer definierten Fläche und einem definierten Abstand zueinander einfach, kostengünstig und sehr präzise reproduzierbar realisiert werden.

Eine raumsparende Anordnung, die zugleich einfach zu reproduzierende Kapazitäten ermöglicht, ergibt sich, wenn die Leiter zumindest im Kopplungsbereich als ebene Leiterbahnen ausgebildet sind.

Besonders bevorzugt wird die Koppelkapazität und die Induktivität mittels flächiger Leiterbahnen, die auf Platinenmaterial aufgebracht werden, realisiert. Vorteilhaft besitzt das Platinenmaterial einen niedrigen Verlustfaktor tan $\delta$. tan $\delta$ sollte kleiner als 0,005 sein, damit die Verluste im Isoliermaterial gering gehalten werden. Als besonders geeignet hat sich in ersten Versuchen RT/duorit 5870 von ROGERS Corp. herausgestellt mit einem tan $\delta$ von 0,0005 - 0,0012 und einem Er von 2,3.

Besonders kostengünstig kann der 3dB-Koppler realisiert werden wenn die Leiterbahnen in einer Multilayerplatine realisiert werden.

Eine Ausgestaltung der Erfindung zeichnet sich dadurch aus, dass die Länge des mindestens einen ersten und/oder zweiten Leiters < $\lambda/4$, bevorzugt < $\lambda/8$, besonders bevorzugt < $\lambda/10$ ist. Bei diesen Größen haben die Einflüsse der Leitungstheorie der Hochfrequenztechnik keine Bedeutung mehr. Bei dem im Rahmen der Erfindung verwendeten 3dB-Koppler handelt es sich nicht um einen Leitungskoppler, wie er aus dem Stand der Technik für höhere Frequenzen bekannt ist, d.h. die Charakteristik des 3dB-Kopplers wird nicht (ausschließlich) durch die Leitungslänge bestimmt. Vielmehr entspricht die Kopplung zwischen den elektrischen Leitern einer kapazitiven Kopplung mit einer fest vorgegebenen und eingestellten Kapazität zwischen den Leitern bei vorgegebener Grundfrequenz f und vorgegebenem Wellenwiderstand $Z_0$. Die Kapazität kann über die Fläche und den Abstand der Leiter eingestellt werden. Weiterhin entspricht die Kopplung einer induktiven Kopplung mit einer fest vorgegebenen und eingestellten Induktivität des Übertragers bei vorgegebener Grundfrequenz f und vorgegebenem Wellenwiderstand $Z_0$. Die Induktivität wird beispielsweise abhängig von der Länge der Leiter, insbesondere der Leiterabschnitte eingestellt.

Bei einer Ausgestaltung der Erfindung ist im Kopplungsbereich zur Erhöhung der Induktivität der Leiter zumindest ein Induktivitätserhöhungselement vorgesehen.

Besonders bevorzugt sind die Abmessungen des 3dB-Kopplers als Einheit kleiner als $\lambda$/10. Besonders bevorzugt ist er bei Frequenzen von 1 bis 30MHz und Leistungen bis zu 12kW kleiner als 20cm x 10 cm x 10cm. So kann der 3dB-Koppler in die derzeitig üblichen kleinen Gehäuseformen der Vakuumplasmageneratoren integriert werden.

Besonders bevorzugt wird der 3dB-Koppler an eine Kühlflüssigkeitskühlung gekoppelt. Dann kann auf eine teure und störanfällige Luftkühlung verzichtet werden. Besonders bevorzugt ist der gesamte Generator kühlflüssigkeitsgekühlt und es findet kein forcierter Luftaustausch z.B. mittels Lüfter vom Innern der Generatoren zur Umgebungsluft statt. Eine forcierte Luftbewegung im Innern des Generators ist dabei möglich, wobei die Wärme über Wärmetauscher von der Luft in die Kühlflüssigkeit transportiert werden kann.

Damit sich das gewünschte Verhalten des 3dB-Kopplers einstellt, sollten die Koppelinduktivität des Übertragers und die Koppelkapazität die folgenden Bedingungen erfüllen:

$$L_K = Z_0 / (2 \pi f)$$

$$C_K = 1/ (2 \pi f Z_0)$$

wobei gilt:

$L_K$ = Koppelinduktivität
$C_k$ = Koppelkapazität
$Z_0$ = Wellenwiderstand
f = Frequenz

Bei 13MHz und $Z_0$ = 50$\Omega$ ergibt sich dann eine Koppelinduktivität $L_K$ von ca. 600nH und eine Koppelkapazität $C_K$ von ca. 200pF.

Üblicherweise werden Vakuumplasmageneratoren mit einem Ausgangswiderstand von 50 Ohm ausgelegt, weil dies der übliche Wert für Anschlusskomponenten und Kabel ist. Da der 3dB-Koppler aber im Inneren des Vakuumgenerators verwendet wird, kann er auch mit niedrigeren Wellenwiderständen realisiert werden. Wenn der 3dB-Koppler einen Wellenwiderstand < 50 Ohm, vorzugsweise < 20 Ohm, aufweist, kann er mit kleineren Abmessungen realisiert werden, da kleinere induktivitätserhöhende Elemente notwendig sind. Wenn die Last eine Impedanz < 50 Ohm aufweist, kann unter Umständen auf ein Impedanzanpassungsnetzwerk verzichtet werden. Wenn eine Impedanzanpassung notwendig ist, wird dagegen eine Impedanzanpassungsnetzwerk zur Anpassung der Impedanz des Generators an die Plasmalast vorgesehen. Das Impedanzanpassungsnetzwerk kann im Generator oder unmittelbar an der Vakuumkammer angeordnet sein. Im ersten Fall bedeutet dies, dass das Ausgangssignal des 3dB-Kopplers mittelbar, nämlich über das Impedanzanpassungsnetzwerk an den Generatorausgang übergeben wird.

Besonders bevorzugt ist es, wenn mindestens zwei Konverter zur Erzeugung von Zwischenkreisspannungen vorgesehen sind, wobei jeder Konverter mindestens einem HF-Signalerzeuger zugeordnet ist. Dadurch ist es möglich, jede Zwischenkreisspannung für sich zu regeln oder zu steuern.

Wenn der mindestens eine Konverter einen Eingang zum Anschluss einer Steuer- und/oder Regeleinrichtung aufweist und wenn der Konverter steuer- und/oder regelbar ist, kann die Zwischenkreisspannung genau eingestellt werden. Insbesondere kann die Zwischenkreisspannung auf einen konstanten Spannungswert gesteuert und/oder geregelt werden.

Vorteilhafterweise ist die Steuer und/oder Regeleinrichtung als programmierbare Logikbaugruppe, insbesondere als DSP, ausgebildet. Bevorzugt erfolgt die Steuerung und/oder Regelung der Inverter (HF-Signal, Phasendifferenz der HF-Signale) und der Konverter (Zwischenkreisspannungen) durch eine Baugruppe, insbesondere eine programmierbare Logikbaugruppe, vorzugsweise einen einzigen DSP.

Bei einer bevorzugten Ausführungsform sind der oder die Konverter als Hochsetzsteller und/oder Tiefsetzsteller ausgebildet. Dadurch ist an ihren Ausgängen eine Spannung von 200V bis 400V einstellbar. Die Netzspannung in unterschiedlichen Ländern ist unterschiedlich. Der Konverter kann an Netzspannungen im Bereich 200V bis 400V angeschlossen werden. Für eine konstante oder geregelte Zwischenkreisspannung von 300V benötigt man sowohl einen Hoch- als auch einen Tiefsetzsteller.

Vorzugsweise werden Netzgleichrichter, Konverter, HF-Signalerzeuger, 3dB-Koppler, ggf. Impulsformungsnetzwerk und Steuerung in einem Metallgehäuse integriert. Dann ist der Vakuumplasmagenerator besonders unempfindlich gegen Störstrahlung und kann besonders stabil arbeiten. Außerdem kann so eine besonders kompakte Bauform erzielt werden.

Vorzugsweise weist der Vakuumplasmagenerator einen Netzeingangsfilter auf. Dann ist der Vakuumplasmagenerator besonders unempfindlich gegen Störungen und Oberwellen aus dem Netz und kann noch stabiler arbeiten.

Vorzugsweise weist der Vakuumplasmagenerator eine Schutzschaltung gegen Überspannungen vom Netz auf und besonders vorzugsweise ebenfalls eine Schutzschaltung gegen Überspannungen vom Generatorausgang. Dann kann der Vakuumplasmagenerator noch stabiler arbeiten.

Bevorzugte Ausführungsbeispiele der Erfindung sind in der Zeichnung schematisch dargestellt und werden nachfolgend mit Bezug zu den Figuren der Zeichnung näher erläutert. Es zeigt:

Fig. 1     ein erstes Ausführungsbeispiel eines Vakuumplasmagenerators;

Fig. 2     ein zweites Ausführungsbeispiel eines Vakuumplasmagenerators;

Fig. 3     ein als Vollbrücke ausgeführter Inverter mit einem Impulsformungsnetzwerk;

Fig. 4     ein als Halbbrücke ausgeführter Inverter mit einem Impulsformungsnetzwerk;

Fig. 5     ein mit einem schaltenden Element ausgeführter Inverter;

Fig. 6     ein als Vollbrücke ausgeführter Inverter mit Entkoppelkondensatoren;

Fig. 7     einen Teil eines Vakuumplasmagenerators mit einem 3dB-Koppler - Netzwerk;

Fig. 8     eine weitere Darstellung eines Teils des Vakuumplasmagenerators mit einem 3dB-Koppler - Netzwerk.

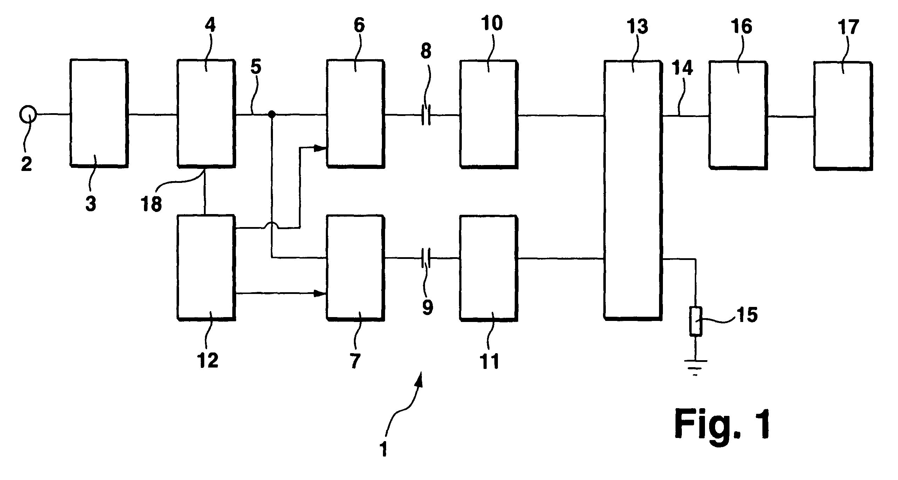

In der Fig. 1 ist ein Vakuumplasmagenerator 1 gezeigt. Der Vakuumplasmagenerator 1 umfasst einen Netzanschluss 2, über den eine Netzspannung einem Netzgleichrichter 3 zugeführt ist. Vor oder nach dem Netzgleichrichter 3 kann auch ein Netzeingangsfilter und eine Schutzschaltung gegen Überspannungen aus dem Netz integriert sein. Die im Netzgleichrichter 3 erzeugte DC-Spannung wird einem Konverter 4 zugeführt, der eine Zwischenkreisspannung erzeugt, die an der Stelle 5 anliegt. Der Konverter 4 kann beispielsweise als DC/DC-Wandler ausgeführt sein. Die Zwischenkreisspannung wird jeweils einem ersten und zweiten HF-Signalerzeuger 6, 7 zugeführt. Im Ausführungsbeispiel sind die HF-Signalerzeuger 6, 7 als Inverter ausgebildet. Über einen Kondensator 8, 9 sind die HF-Signalerzeuger 6, 7 an Impulsformungsnetzwerke 10, 11 angeschlossen. Eine Steuer- und/oder Regeleinrichtung 12 steuert die HF-Signalerzeuger 6, 7. Über die Steuer- und/oder Regeleinrichtung 12 können sowohl die Amplitude als auch die Phase der Ausgangssignale der HF-Signalerzeuger 6, 7 eingestellt werden. Außerdem kann über die Steuer- und/oder Regeleinrichtung 12, die als Logikbaustein ausgebildet ist, die Frequenz der Ausgangssignale der HF-Signalerzeuger 6,7 eingestellt werden. Insbesondere wird die Phasenlage der Ausgangssignale der HF-Signalerzeuger 6, 7 derart eingestellt, dass die an einem 3dB-Koppler 13 anliegenden Signale einen Phasenversatz von 90° aufweisen. Dadurch wird eine optimale Leistungskopplung am Ausgang 14 erreicht. Am Lastausgleichswiderstand 15 wird bei optimaler Phasenlage und angepasster Last keine Energie verbraucht. Zur Impedanzanpassung kann ein Impedanzanpassungsnetzwerk 16 zwischen den 3dB-Koppler 13 und die Vakuumkammer 17 geschaltet sein.

Die Regel- und/oder Steuereinrichtung 12 ist außerdem mit einem Steuereingang 18 des Konverters 4 verbunden. Dadurch ist die Zwischenkreisspannung, die an der Stelle 5 anliegt, einstellbar.

Eine Schutzschaltung gegen Überspannungen vom Generatorausgang kann direkt am Generatorausgang 14 oder im Verlauf der Signalerzeugerpfade 6,8,10 bzw. 7,9,11 angeordnet sein, wo immer der wirkungsvollste Schutz zu erreichen ist bzw. wo die empfindlichsten Bauteile gegenüber Überspannung liegen.

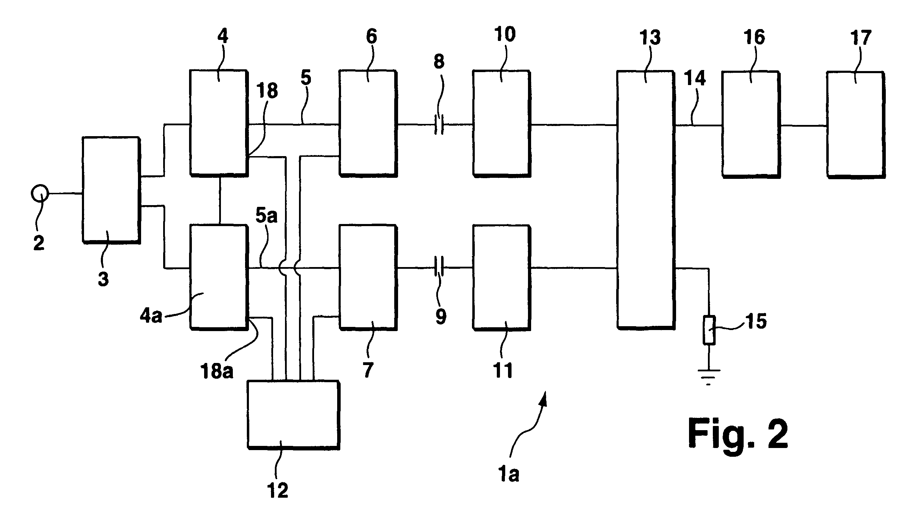

Im Unterschied zur Fig. 1 sind in der Fig. 2, in der Elemente gleicher Funktion mit derselben Bezugsziffer wie in der Fig. 1 versehen sind, zwei Konverter 4, 4a vorgesehen, die jeweils eine Zwischenkreisspannung an den Stellen 5, 5a erzeugen. Dementsprechend steuert die Steuer- und/oder Regeleinrichtung 12 den Konverter 4 und den Konverter 4a. Die Regel- und/oder Steuereinrichtung 12 ist als eine Einheit dargestellt. Es ist jedoch auch denkbar, die Regel- und/oder Steuereinheit 12 in Steuerkomponenten zu unterteilen, die zum einen für die Konverter 4, 4a und zum anderen für die HF-Signalerzeuger 6, 7 zuständig sind. Es ist auch denkbar mehrere separate Steuer- und/oder Regeleinrichtungen vorzusehen.

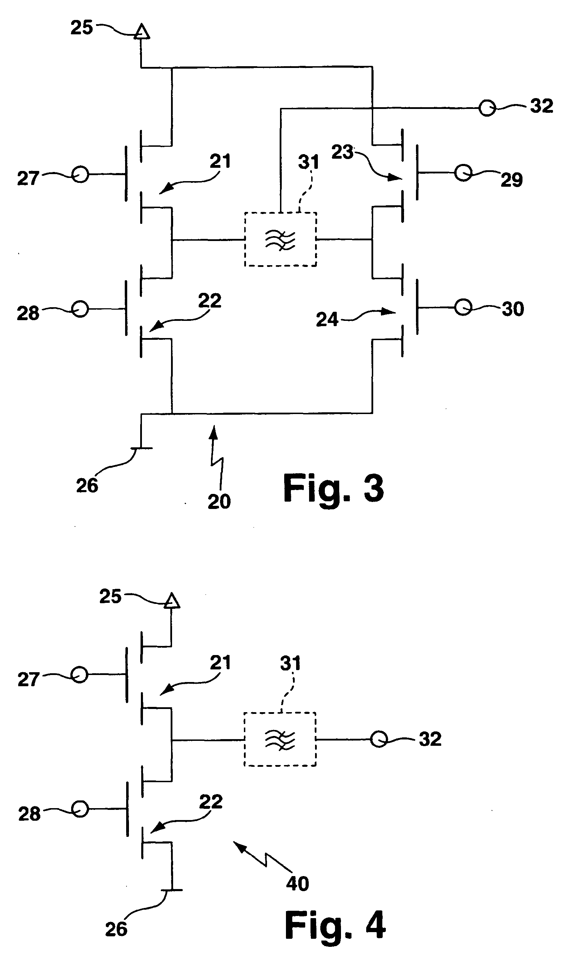

In Fig. 3 ist ein als Inverter ausgebildeter HF-Signalerzeuger 20 dargestellt, der eine Vollbrücke aufweist. Die Vollbrücke besteht aus vier als MOS-FET Transistoren ausgebildeten schaltenden Elementen 21 - 24. Mit der Klemme 25 ist der HF-Signalerzeuger 20 an die positive Zwischenkreisspannung angeschlossen und mit der Klemme 26 ist er an die negative Zwischenkreisspannung bzw. an das niedrigere Potenzial der Zwischenkreisspannung angeschlossen. Die schaltenden Elemente 21 - 24 weisen Anschlüsse 27 - 30 auf, die Steueranschlüsse der schaltenden Elemente 21 - 24 darstellen. In die Vollbrücke ist ein als Bandpassfilter wirkendes Impulsformungsnetzwerk 31 geschaltet, das einen HF-Signalausgang 32 aufweist. In einer besonders bevorzugten Ausführungsform ist das Impulsformungsnetzwerk 31 nicht als Bandpassfilter, sondern als Tiefpassfilter aus mehreren LC-Gliedern realisiert.

In der Fig. 4 ist ein als Inverter ausgebildeter HF-Signalerzeuger 40 dargestellt, der eine Halbbrücke aufweist. Die Halbbrücke besteht in diesem Fall aus zwei als MOS-FET Transistoren ausgebildeten schaltenden Elementen 21, 22, die in der Serie geschaltet sind. Diese weisen ebenfalls als Steuereingänge verwendete Anschlüsse 27, 28 auf. Der HF-Signalerzeuger 40 ist über die Anschlüsse 25, 26 ebenfalls an die Zwischenkreisspannung anschließbar. Über das Impulsformungsnetzwerk 31 liefert der HF-Signalerzeuger 40 ein hochfrequentes Signal an den HF-Signalausgang 32.

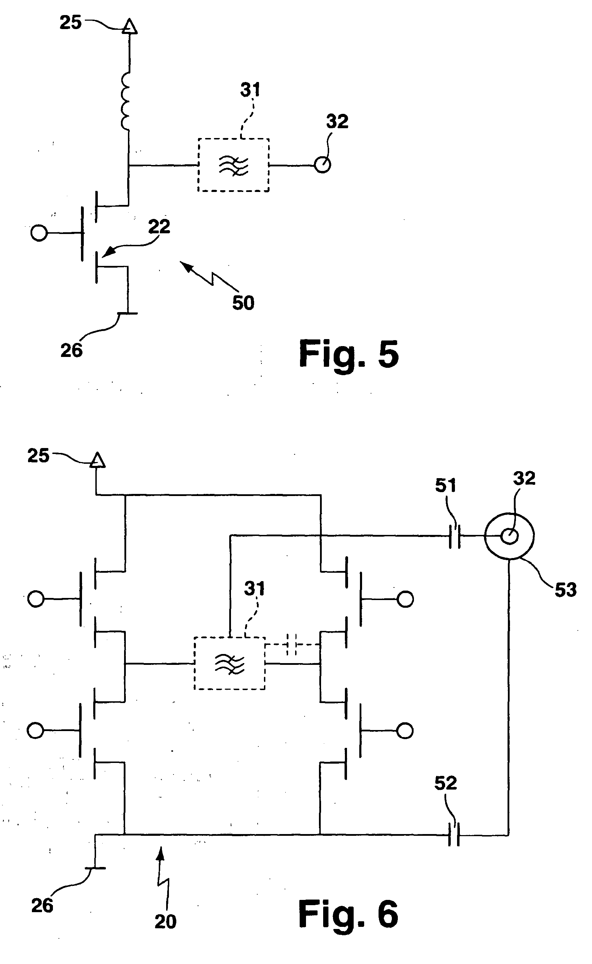

Der in der Fig. 5 dargestellte als Inverter ausgebildete HF-Signalerzeuger 50 ist über die Klemmen 25, 26 wiederum an eine Zwischenkreisspannung anschließbar. Der HF-Signalerzeuger 50 weist nur ein einziges als MOS-FET Transistor ausgebildetes schaltendes Element 27 auf. Über das Impulsformungsnetzwerk 31 liefert der HF-Signalerzeuger 50 ein hochfrequentes Signal an den HF-Signalausgang 32. Der HF-Signalerzeuger 50 ist auch als Klasse E Verstärker bekannt.

In der Fig. 6 ist im Wesentlichen wieder der HF-Signalerzeuger 20 gezeigt, der an ein Impulsformungsnetzwerk 31 angeschlossen ist. Zur galvanischen Entkopplung sind Kondensatoren 51, 52 vorgesehen. Der Kondensator 51 ist zwischen das Impulsformungsnetzwerk 31 und den HF-Signalausgang 32 geschaltet. Der Kondensator 52 ist zwischen die Klemme 26 und den Masseanschluss 53 des Generators geschaltet. Zusätzlich hat sich ein Kondensator von Anschluss 25 zum Masseanschluss 53 (nicht in Fig. 6 gezeigt) als vorteilhaft erwiesen. Auch in der Schaltung in Fig. 6 ist in einer besonders bevorzugten Ausführungsform das Impulsformungsnetzwerk 31 nicht als Bandpassfilter, sondern als Tiefpassfilter aus mehreren LC-Gliedern realisiert.

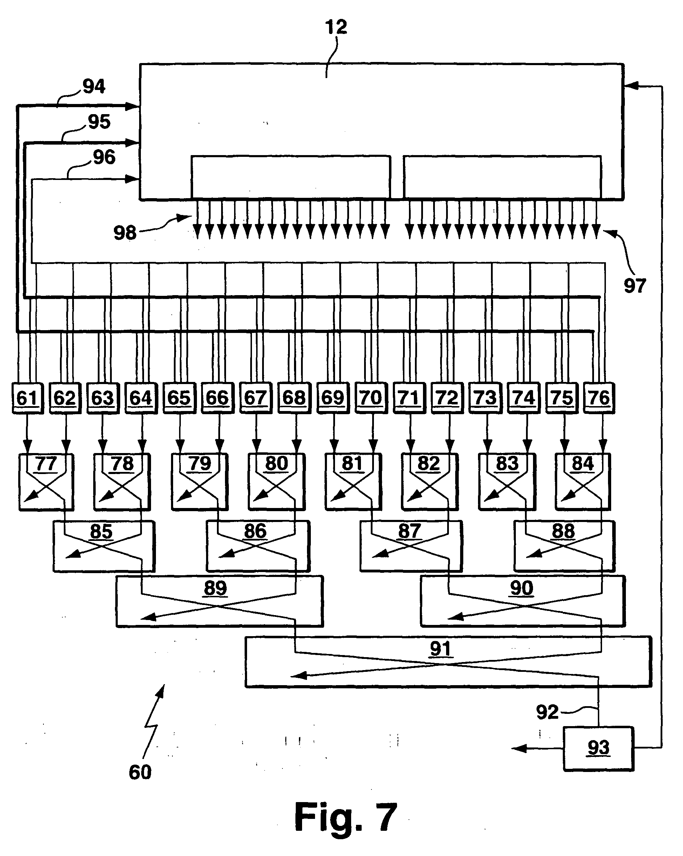

In der Fig. 7 ist ein Teil eines Vakuumplasmagenerators 60 gezeigt. Der Vakuumplasmagenerator 60 weist eine zentrale Steuer- und/oder Regeleinrichtung 12 auf. An die Steuer- und/oder Regeleinrichtung 12 sind sechzehn Module 61 - 76 angeschlossen. In den Modulen 61 - 76 sind jeweils ein HF-Signalerzeuger und ein Impulsformungsnetzwerk enthalten. Jeweils zwei Module 61 - 76 sind auf einen 3dB-Koppler 77 - 84 geschaltet. In einer nächsten Stufe sind jeweils zwei 3dB-Koppler 77 - 84 auf einen 3dB-Koppler 85 - 88 geschaltet. In einer dritten Stufe sind zwei 3dB-Koppler 89, 90 und in einer vierten Stufe ein 3dB-Koppler 91 vorgesehen. Am Ausgang 92 des 3dB-Kopplers 91 liegt die HF-Leistung, die der Vakuumkammer zugeführt werden kann, an. Diese Leistung wird durch eine Messeinrichtung 93 erfasst und an die Regel- und/oder Steuereinrichtung 12 übergeben. Die Regel- und/oder Steuereinrichtung 12 steht über Datenleitungen 94 für analoge Signale, eine Schnittstelle 95 und eine Fehlermeldungsleitung 96 mit den Modulen 61 - 76 in Datenaustauschverbindung. Weiterhin weist die Regel- und/oder Steuereinrichtung 12 sechzehn synchrone Taktausgänge 97 auf, wobei jeweils ein Ausgang einem Modul 61 - 76 zugeführt ist. Über diese Ausgänge 97 werden die HF-Signalerzeuger mit einer Grundfrequenz getaktet. Die Signale der Taktausgänge 97 sind nicht phasengleich. Dadurch kann die Phasenlage der Ausgangssignale der Module 61 - 76 eingestellt werden. Weiterhin weist die Regel - und/oder Steuereinrichtung 12 sechzehn synchrone Pulsausgänge 98 auf. Diese werden benötigt, wenn das HF-Ausgangssignal des Vakuumplasmagenerators 60 nicht kontinuierlich sondern gepulst anliegen soll.

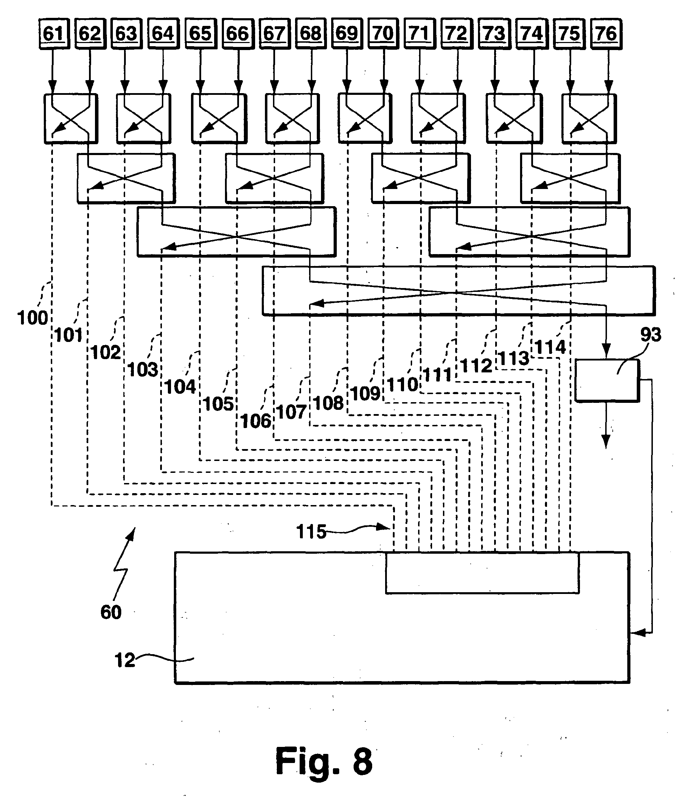

In der Darstellung der Fig. 8 ist der Vakuumplasmagenerator 60 nochmals gezeigt. An den Ausgängen 100 - 114 der 3dB-Koppler 77 - 91 sind nicht dargestellte Lastausgleichswiderstände angeordnet. Die an den Lastausgleichswiderständen anliegenden Spannungen werden über fünfzehn analoge Eingänge 115 an die Regel- und Steuereinrichtung 12 übergeben. Die so erfassten Spannungen sind ein Maß für die Impedanzanpassung, Phasenlage der Signale der HF-Signalerzeuger zueinander und Leistungssymmetrie der Signale der HF-Signalerzeuger zueinander. Sie können weiterhin zur Regelung des Vakuumplasmagenerators 60 verwendet werden.

**Patentansprüche**

1.  Vakuumplasmagenerator (1, 1a, 60) zur Behandlung von Werkstücken in einer Vakuumkammer (17), wobei dieser aufweist:

    - einen Netzanschluss (2) für den Anschluss an ein Spannungsversorgungsnetz;
    - mindestens einen Netzgleichrichter (3), verbunden mit
    - mindestens einem ersten Konverter (4, 4a) zur Erzeugung mindestens einer Zwischenkreisspannung;
    - einen ersten an die mindestens eine Zwischenkreisspannung angeschlossenen HF-Signalerzeuger (6, 7, 20, 40, 50) zur Erzeugung eines ersten Signals einer Grundfrequenz, insbesondere im Bereich von 1 bis 30MHz, und einer ersten Phasenlage; **dadurch gekennzeichnet, dass** er
    - einen zweiten an eine Zwischenkreisspannung angeschlossenen HF-Signalerzeuger (6, 7, 20, 40, 50) zur Erzeugung eines zweiten Signals der Grundfrequenz und einer zweiten Phasenlage; aufweist;
    - mindestens einen 3dB-Koppler (13, 77 - 91), der das erste und das zweite Signal zu einem Ausgangssignal koppelt und an
    - einen Generatorausgang (14, 92) mittelbar oder unmittelbar übergibt.

2.  Generator nach Anspruch 1, **dadurch gekennzeichnet, dass** der erste und zweite HF-Signalerzeuger (6, 7, 20, 40, 50) jeweils als Inverter ausgebildet sind, die von einer Steuer- und/oder Regeleinrichtung (12) angesteuert sind.

3.  Generator nach Anspruch 2, **dadurch gekennzeichnet, dass** die Inverter jeweils eine Halb- oder Vollbrücke aufweisen.

4.  Generator nach einem der vorhergehenden Ansprüche, d**adurch gekennzeichnet, dass** zumindest ein Kondensator (8, 9, 51, 52) zur galvanischen Entkopplung vorgesehen ist.

5.  Generator nach einem der vorhergehenden Ansprüche, **dadurch gekennzeichnet, dass** dem ersten und zweiten HF-Signalerzeuger (6, 7, 20, 40, 50) jeweils ein Impulsformungsnetzwerk (10, 11, 31) nachgeschaltet ist.

**6.** Generator nach einem der vorhergehenden Ansprüche, **dadurch gekennzeichnet, dass** der 3dB-Koppler (13, 77 - 91) mindestens einen ersten und einen zweiten elektrischen Leiter, die voneinander beabstandet sind, und die kapazitiv und induktiv miteinander gekoppelt sind, aufweist, wobei der erste Leiter die Primärseite und der zweite Leiter die Sekundärseite eines Übertragers darstellen und der erste und der zweite Leiter jeweils eine Windungszahl n > 1 aufweisen.

**7.** Generator nach einem der vorhergehenden Ansprüche, **dadurch gekennzeichnet, dass** der 3dB-Koppler (13, 77 - 91) mindestens einen ersten und einen zweiten elektrischen Leiter, die voneinander beabstandet sind, und die kapazitiv und induktiv miteinander gekoppelt sind, aufweist, wobei der erste Leiter die Primärseite und der zweite Leiter die Sekundärseite eines Übertragers darstellen und in einem Kopplungsbereich zur Erhöhung der Induktivität der Leiter zumindest ein Induktivitätserhöhungselement vorgesehen ist.

**8.** Generator nach einem der vorhergehenden Ansprüche, **dadurch gekennzeichnet, dass** die Länge des mindestens einen ersten und/oder zweiten Leiters < $\lambda/4$, bevorzugt < $\lambda/8$, besonders bevorzugt < $\lambda/10$ ist.

**9.** Generator nach einem der vorhergehenden Ansprüche, **dadurch gekennzeichnet, dass** der 3dB-Koppler (13, 77 - 91) einen Wellenwiderstand < 50 Ohm, vorzugsweise < 20 Ohm, aufweist.

**10.** Generator nach einem der vorhergehenden Ansprüche, **dadurch gekennzeichnet, dass** mindestens zwei Konverter (4, 4a) zur Erzeugung von Zwischenkreisspannungen vorgesehen sind, wobei jeder Konverter (4, 4a) mindestens einem HF-Signalerzeuger (5, 6, 20, 40, 50) zugeordnet ist.

**11.** Generator nach einem der vorhergehenden Ansprüche, **dadurch gekennzeichnet, dass** der mindestens eine Konverter (4, 4a) einen Eingang (18, 18a) zum Anschluss einer Steuer- und/oder Regeleinrichtung (12) aufweist.

**12.** Generator nach einem der vorhergehenden Ansprüche, **dadurch gekennzeichnet, dass** die Steuer und/oder Regeleinrichtung (12) als programmierbare Logikbaugruppe, insbesondere als DSP, ausgebildet ist.

**13.** Generator nach einem der vorhergehenden Ansprüche, **dadurch gekennzeichnet, dass** an den Vakuumplasmagenerator (1, 1a, 60) eine Impedanzanpassungsschaltung (16) zur Anpassung der Impedanz des Generators (1, 1a, 60) an eine Plasmalast vorgesehen ist.

**14.** Generator nach einem der vorhergehenden Ansprüche, **dadurch gekennzeichnet, dass** der oder die Konverter (4, 4a) als Hoch- und/oder Tiefsetzsteller ausgebildet sind.

**Claims**

**1.** Vacuum plasma generator (1, 1a, 60) for treating workpieces in a vacuum chamber (17), comprising:

- a mains connection (2) for connection to a voltage supply network;
- at least one mains rectifier (3) which is connected to
- at least one first converter (4, 4a) for generating at least one intermediate circuit voltage;
- a first RF signal generator (6, 7, 20, 40, 50) which is connected to the at least one intermediate circuit voltage, for generating a first signal of a basic frequency, in particular, in the range between 1 and 30 MHz, and of a first phase position, **characterized in that** it comprises a second RF signal generator (6, 7, 20, 40, 50) which is connected to an intermediate circuit voltage, for generating a second signal of the basic frequency, and of a second phase position;
- at least one 3dB coupler (13, 77-91) which couples the first and the second signal into an output signal, transferring it
- indirectly or directly to a generator output (14, 92).

**2.** Generator according to claim 1, **characterized in that** the first and second RF signal generators (6, 7, 20, 40, 50) are each designed as inverters which are driven by an open-loop and/or closed-loop control means (12).

**3.** Generator according to claim 2, **characterized in that** each inverter has one half-bridge or full bridge.

**4.** Generator according to any one of the preceding claims, **characterized in that** at least one capacitor (8, 9, 51, 52) is provided for galvanic decoupling.

**5.** Generator according to any one of the preceding claims, **characterized in that** a pulse shaping network (10, 11, 31) is connected downstream of each of the first and second RF signal generators (6, 7, 20, 40, 50).

**6.** Generator according to any one of the preceding claims, **characterized in that** the 3dB coupler (13, 77-91) comprises at least one first and one second electric conductor which are spaced apart and are capacitively and inductively coupled to each other, wherein the first conductor represents the primary side and the second conductor the secondary side of a transformer, the first and second conductors each having a winding number of n>1.

7. Generator according to any one of the preceding claims, **characterized in that** the 3dB coupler (13, 77-91) comprises at least one first and one second electric conductor which are spaced apart, and are capacitively and inductively coupled to each other, wherein the first conductor represents the primary side and the second conductor the secondary side of a transformer, and wherein at least one inductance increasing element is provided in a coupling region to increase the inductance of the conductors.

8. Generator according to any one of the preceding claims, **characterized in that** the length of the at least one first and/or second conductor is $<\lambda/4$, preferably $<\lambda/8$, with particular preference $<\lambda/10$.

9. Generator according to any one of the preceding claims, **characterized in that** the 3dB coupler (13, 77-91) has a characteristic wave impedance of <50 ohms, preferably <20 ohms.

10. Generator according to any one of the preceding claims, **characterized in that** at least two converters (4, 4a) are provided to generate intermediate circuit voltages, wherein each converter (4, 4a) is associated with at least one RF signal generator (5, 6, 20, 40, 50).

11. Generator according to any one of the preceding claims, **characterized in that** the at least one converter (4, 4a) comprises an input (18, 18a) for connecting an open-loop and/or closed-loop control means (12).

12. Generator according to any one of the preceding claims, **characterized in that** the open-loop and/or closed-loop control means (12) is designed as programmable logic component, in particular, as DSP.

13. Generator according to any one of the preceding claims, **characterized in that** an impedance matching circuit (16) is provided at the vacuum plasma generator (1, 1a, 60) for adjusting the impedance of the generator (1, 1a, 60) to a plasma load.

14. Generator according to any one of the preceding claims, **characterized in that** the converter/s (4, 4a) is/are designed as boost and/or buck converters.

**Revendications**

1. Générateur de plasma sous vide (1, 1a, 60) destiné au traitement de pièces à usiner dans une chambre à vide (17), celui-ci présentant :

   - Un raccordement réseau (2) pour le raccordement à un réseau d'alimentation en courant ;
   - au moins un redresseur de secteur (3), relié à
   - au moins un premier convertisseur (4, 4a) destiné à la génération d'au moins une tension de circuit intermédiaire ;
   - un premier générateur de signal HF (6, 7, 20, 40, 50) connecté à la au moins une tension de circuit intermédiaire pour la génération d'un premier signal d'une fréquence de base, en particulier dans la plage de 1 à 30 MHz, et d'une première position de phase, **caractérisé en ce qu'**il
   - présente un second générateur de signal HF (6, 7, 20, 40, 50) connecté à une tension de circuit intermédiaire pour la génération d'un second signal de la fréquence de base et d'une seconde position de phase ;
   - au moins un coupleur 3dB (13, 77 - 91), lequel couple le premier et le second signal pour former un signal de sortie et
   - le transmet directement ou indirectement à une sortie de générateur (14, 92).

2. Générateur selon la revendication 1, **caractérisé en ce que** le premier et le second générateur de signal HF (6, 7, 20, 40, 50) sont chacun configurés sous forme d'inverseurs, lesquels sont commandés par un dispositif de commande et/ou de réglage.

3. Générateur selon la revendication 2, **caractérisé en ce que** les inverseurs présentent chacun un demi-pont ou un pont intégral.

4. Générateur selon l'une quelconque des revendications précédentes, **caractérisé en ce qu'**au moins un condensateur (8, 9, 51, 52) est prévu pour le découplage galvanique.

5. Générateur selon l'une quelconque des revendications précédentes, **caractérisé en ce qu'**un réseau de formation d'impulsion (10, 11, 31) est respectivement placé en aval du premier et du second générateur de signal HF (6, 7, 20, 40, 50).

6. Générateur selon l'une quelconque des revendications précédentes, **caractérisé en ce que** le coupleur 3dB (13, 77 - 91) présente au moins un premier et un second conducteur électrique qui sont distants l'un de l'autre et qui sont couplés entre eux de manière inductive et de manière capacitive, le premier conducteur constituant le côté primaire et le second conducteur le côté secondaire d'un transmetteur et le premier et le second conducteur présentant chacun un nombre de spires n > 1.

7. Générateur selon l'une quelconque des revendications précédentes, **caractérisé en ce que** le coupleur 3dB (13, 77 - 91) présente au moins un premier et un second conducteur électrique qui sont distants l'un de l'autre et qui sont couplés entre eux de manière inductive et de manière capacitive, le premier conducteur constituant le côté primaire et le second conducteur le côté secondaire d'un transmetteur et au moins un élément d'augmentation de l'inductance étant prévu dans une zone de couplage pour l'augmentation de l'inductance des conducteurs.

8. Générateur selon l'une quelconque des revendications précédentes, **caractérisé en ce que** la longueur d'au moins un premier et/ou second conducteur est < $\lambda$/4, de préférence < $\lambda$/8, particulièrement de préférence < $\lambda$/10.

9. Générateur selon l'une quelconque des revendications précédentes, **caractérisé en ce que** le coupleur 3dB (13, 77 - 91) présente une impédance caractéristique < 50 ohms, de préférence < 20 ohms.

10. Générateur selon l'une quelconque des revendications précédentes, 5**caractérisé en ce qu'**au moins deux convertisseurs (4, 4a) sont prévus pour la génération de tensions de circuit intermédiaire, chaque convertisseur (4, 4a) étant associé à au moins un générateur de signal HF (5, 6, 20, 40, 50).

11. Générateur selon l'une quelconque des revendications précédentes, **caractérisé en ce qu'**au moins le convertisseur (4, 4a) présente une entrée (18, 18a) pour le raccordement d'un dispositif de commande et/ou de réglage (12).

12. Générateur selon l'une quelconque des revendications précédentes, **caractérisé en ce que** le dispositif de commande et/ou de réglage (12) est conçu en tant qu'élément logique programmable, en particulier en tant que DSP.

13. Générateur selon l'une quelconque des revendications précédentes, **caractérisé en ce qu'**un montage d'adaptation d'impédance (16) pour l'adaptation de l'impédance du générateur (1, 1a, 60) à une charge de plasma est prévu sur le générateur à plasma sous vide (1, 1a, 60).

14. Générateur selon l'une quelconque des revendications précédentes, **caractérisé en ce que** le ou les convertisseurs (4, 4a) est/sont conçu(s) en tant que hacheurs parallèle et/ou hacheurs série.

Fig. 1

Fig. 2

**Fig. 3**

**Fig. 4**

**Fig. 5**

**Fig. 6**

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6703080 B2